# EUROPÄISCHE PATENTANMELDUNG

(11) **EP 2 177 926 A1**
(43) Veröffentlichungstag der Anmeldung: **21.04.2010**
(21) Anmeldenummer: 09012500.6
(22) Anmeldetag: 02.10.2009
(51) Int. Cl.: G01R 35/04, B60L 3/12

(54) **Einrichtung zur Überprüfung eines Elektrizitätszählers an Bord eines elektrisch angetriebenen Zuges**

(30) Priorität: 16.10.2008 IT MI20081833
(71) Anmelder: TEM ELETTRONICA S.r.l. unipersonale, 26900 Lodi (IT)
(72) Erfinder: Ardemagni, Pierenrico, 26900 Lodi (IT); Dossena, Livia, 2699 Lodi (IT)
(74) Vertreter: Mayer, Hans Benno

(57) **Zusammenfassung**

Einrichtung zur Überprüfung eines Elektrizitätszählers, an Bord eines elektrisch angetriebenen Zuges, wobei ein Wagen mit Rädern zum Verschieben einen Generator (5) zur Erzeugung von Signalen aufnimmt und der Generator über Verbindungen (6), Verstärker (7,8) überwacht, die ihrerseits mit Transformatoren (9,10) verbunden sind und deren Hochspannungs-Sekundärwicklung die Spannung und den Strom für die Überprüfung liefert und ferner vorgesehen ist, dass die Ausgänge eines Gleichrichters (14), der Transformatoren (9,10) sowie eines Gleichspannungs-Generators (12) neben einer Verbindung mit dem Elektrizitätszähler (16) auch mit einer Prüfvorrichtung (20) verbunden sind und ferner vorgesehen ist, dass der Generator (5) über eine entfernt angeordnete Kontrolleinrichtung (27) gesteuert wird und diese Kontrolleinrichtung elektrisch isoliert von der Überwachungseinrichtung angeordnet ist.

## Beschreibung

Die vorstehende Erfindung betrifft eine Vorrichtung zum Überprüfen einer Einrichtung des Typs 'Energy Meter', die an Bord eines elektrisch angetriebenen Zuges angeordnet ist.

Es sind in Europa Richtlinien in Kraft getreten, welche den freien Betrieb in Europa und somit das freie Befahren von Zügen in Europa ermöglichen.

Über die europäische Norm EN 50463 werden Merkmale festgelegt, die für sogenannte Einrichtungen 'Energy Meter' gelten, die an Bord von Zügen einzusetzen sind.

Diese Vorrichtung hat die Aufgabe die aufgenommene elektrische Energie bzw. die abgegebene elektrische Energie eines jeden Zuges, der ein europäisches Land befährt zu registrieren.

Mit der Einrichtung 'Energy Meter' wird es möglich auf automatiche Weise die vom Zug aufgenommene elektrische Energie in jedem durchfahreren Land zu registrieren, dies gilt für alle Eisenbahnzüge, die mit elektrischer Energie angetrieben werden.

Die Vorrichtung 'Energy Meter' ist über eine europäisches Anstalt, die zur Überprüfung ermächtigt ist, zuzulassen und zu bescheinigen.

Die bestehende Norm sieht ferner vor, dass die Einrichtung 'Energy Meter' von Zeit zu Zeit im Zug einer Prüfung zu unterziehen ist, um zu gewährleisten, dass die eingebaute Vorrichtung 'Energy Meter' den gültigen europäischen Normen, hinsichtlich Genauigkeit, entspricht.

Die Norm, die ein Befahren der Züge in europäischen Ländern regelt, bestimmt mit welcher Nominalspannung diese elektrisch betriebenen Züge anzutreiben sind.

Es ist zu berücksichtigen, dass einige Züge auch mit unterschiedlichen Spannungen betrieben werden können, dies erfordert aber eine besondere Ausbildung der Vorrichtungen für den elektrischen Antrieb des Zuges.

Die meistens verwendeten Spannungswerte sind folgende:
- 750 Volt Gleichspannung
- 1500 Volt Gleichspannung
- 4000 Volt Gleichspannung
- 15000 Volt Wechselspannung zu 16,66 Hz und
- 25000 Volt Wechselspannung zu 50 Hz

Die Unternehmen, die den Zugverkehr in den verschiedenen europäischen Staaten verwalten, haben die Pflicht in regelmäßigen Abständen die Vorrichtung des Typs 'Energy Meter', die in den Zügen installiert sind, zu überprüfen, um das ordnungsgemäße Arbeiten dieser Vorrichtung festzustellen oder Instandhaltungsarbeiten sowie Austausch beschädigter Bauteile vorzunehmen, z.B. bei Auftreten von Überspannungen oder aufgrund von Beschädigungen der Vorrichtung durch Blitzschlag.

Zur Zeit sind für diese Vorgänge lange und aufwändige Handlungen vorzunehmen, so ist die Vorrichtung 'Energy Meter' auszubauen, dies gilt auch für die Serie der Hochspannungstransduktoren und diese Vorrichtungen sind in eine Spezialwerkstatt zu schicken, um dort ein Überprüfen der einzelnen Vorrichtungen des Gerätes durchzuführen.

Es ist naheliegend, dass die vorher genannten Handlungen nicht zufriedenstellend sein können, unter Berücksichtigung der Erfordernisse, die in der Praxis auftreten.

Es ist daher Aufgabe der vorstehenden Erfindung eine bewegbare Kontrolleinrichtung vorzuschlagen, die nicht fest im Zug eingebaut ist, und es zu jederzeit ermöglicht, die in der Lokomotive des Zuges eingebaute Vorrichtung des Typs 'Energy Meter' einer Prüfung zu unterziehen.

Diese Aufgabe wird dadurch erreicht, dass die Vorrichtung für die Überprüfung einer Einrichtung des Typs 'Energy Meter', die an Bord eines elektrisch angetriebenen Zuges installiert ist, einen mit Rädern ausgerüsteten Schiebewagen und einen Generator für die Abgabe von Signalen aufweist, der über Verbindungspunkte Verstärker überwacht, die ihrerseits mit Transformatoren verbunden sind, deren Hochspannungs-Sekundärwicklung die Spannung und den Strom für die Überprüfung der Vorrichtung des Typs 'Energy Meter' liefert, wobei der Generator weitere zwei Ausgänge aufweist und der erste Ausgang mit einem Gleichstrom-Generator und der zweite Ausgang, unter Zwischenschaltung eines Unterbrechers, der den Transformators mit einem Gleichrichter verbindet, dessen Ausgänge mit der Vorrichtung des Typs 'Energy Meter' wirkverbunden sind und ferner vorgesehen ist, dass die Ausgänge des Gleichrichters der Transformatoren sowie des Generators, neben einer Verbindung mit der Vorrichtung 'Energy Meter' auch mit einer Prüfvorrichtung verbunden sind und ferner vorgesehen ist, dass der Generator über eine entfernt angeordnete Kontrolleinrichtung gesteuert wird und diese Kontrolleinrichtung elektrisch isoliert von der Überwachungseinrichtung vorgesehen ist.

In vorteilhafter Weise wird eine entfernt angeordnete Vorrichtung eingesetzt, die mit dem Rest der Einrichtung in wireless Anordnung oder über optische Fasern verbunden ist, wodurch eine größere elektrische Sicherheit gewährleistet werden kann.

Ferner findet ein Generator Einsatz, dessen Form der Testwellen veränderbar ist und mit dem Terminal in Verbindung steht, wodurch sich die Möglichkeit eröffnet auch unterschiedliche Testvorgänge nach Standardverfahren durchzuführen.

Es hat sich auch als vorteilhaft erwiesen, Verstärker mit Radiofrequenz zu verwenden, um somit den Transformatoren die notwendige Potenz zu liefern.

Besonders vorteilhaft ist es, die gesamte Einrichtung bis zum Dach des Zuges anzuheben, um somit größtmögliche Sicherheit zu gewähren und gleichzeitig die elektrische Verbindung zu vereinfachen.

Es hat sich auch als vorteilhalt erwiesen, in einer einzigen Vorrichtung sowohl den Generator als auch die Bezugsbauteile unterzubringen, um somit die Messungen vollständig und ausführlich durchführen zu können.

Die erfindungsgemäße Einrichtung arbeitet vollkommen eigenständig und unabhängig von anderen Bauteilen des Zuges, der mit elektrischem Strom angetrieben wird, gleichzeitig wird es ermöglicht unter Einsatz einfacher Montagevorgänge, die gesamte Einrichtung abzubauen und an eine Werkstatt zu liefern, um somit die amtliche Prüfbescheinigung zu erhalten.

Schließlich ist es vorteilhalt in einer einzigen Vorrichtung sowohl den Generator für Spannung und Gleichstrom als auch den Generator für Spannung und Wechselstrom unterzubringen, wodurch sich die Möglichkeit eröffnet, sämtliche Züge, die in Europa mittels unterschiedlicher Spannungen verkehren zu betreiben.

Der Erfindungsgegenstand wird nun genauer beschrieben und in den Zeichnungen dargestellt, es zeigen:
Figur 1 eine Vorrichtung gemäß der vorstehenden Erfindung, die in einem Gehäuse untergebracht ist, das von einem Laufwagen aufgenommen wird;
Figur 2 in Vorderansicht die Vorrichtung nach Figur 1; und
Figur 3 den elektrischen und elektronischen Schaltkreis der Vorrichtung gemäß der vorstehenden Erfindung.

Die erfindungsgemäße Vorrichtung ist gesamthaft mit 1 gekennzeichnet und auf einem Wagen 2 angeordnet, der mit Rädern 3 für ein bequemes Verfahren ausgerüstet ist.

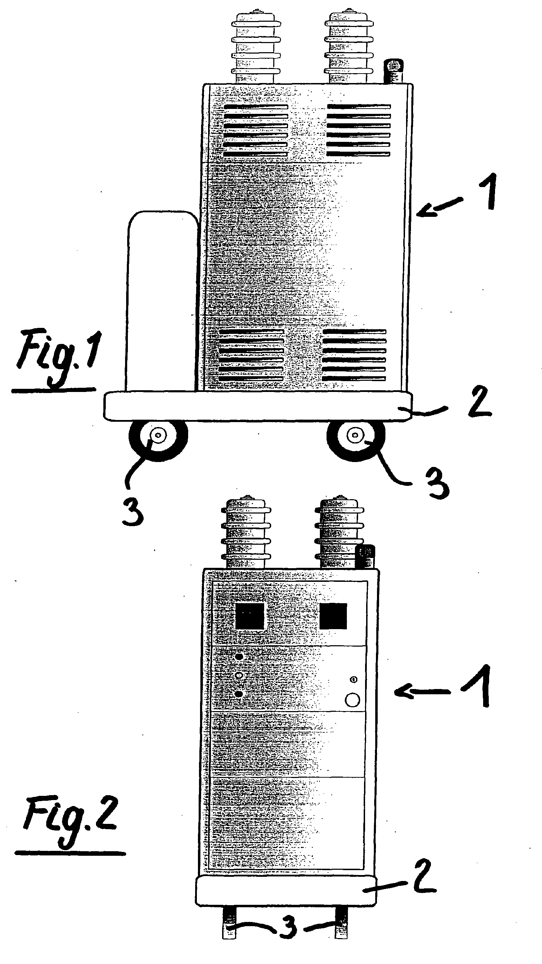

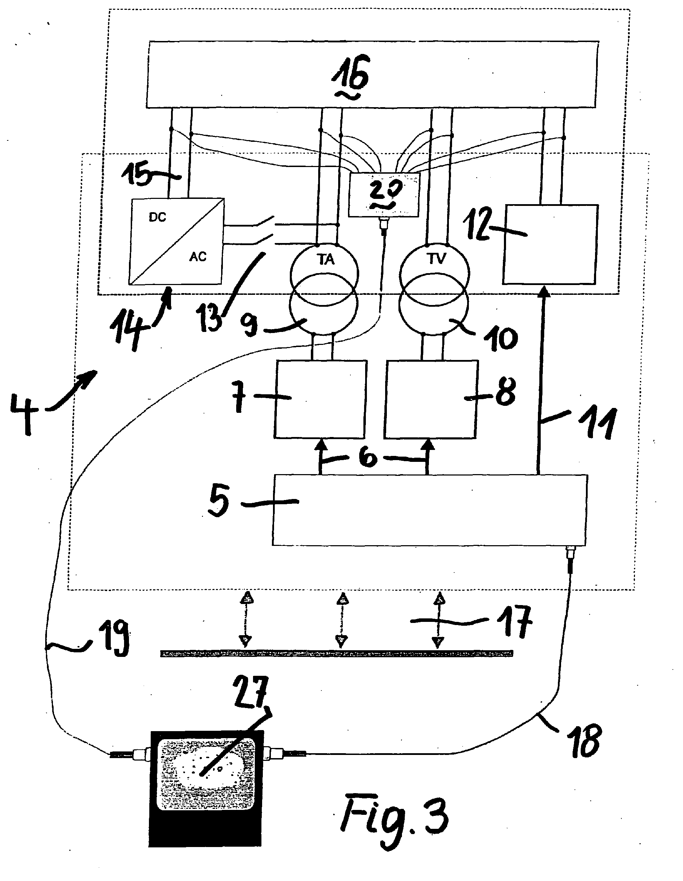

Die Vorrichtung, die in der Einrichtung gemäß Figur 1 und 2 aufgenommen ist, ist im Detail in Figur 3 dargestellt und gesamthaft mit dem Bezugszeichen 4 gekennzeichnet.

Die Vorrichtung 4 weist einen Generator 5 auf, der an den Ausgängen 6 Signale abgibt, die geeignet sind, die Verstärker 7 und 8 zu erregen und diese Verstärker erlauben es, über Transformatoren 9 und 10 eine Ausgangsspannung zu liefern, die in einer Größe von ca. 5 kV bis 35 kV und einer Stromstäke bis zu 1500 A steht.

Der Generator 5 liefert ferner über den Ausgang 11 ein Ausgangssignal, das geeignet ist, an einen zweiten Generator 12 angelegt zu werden, wodurch es ermöglicht wird, eine Gleichspannung in einer Größenordnung von 0 bis 5 kV zu bilden.

Der Generator 5 liefert ferner einen Steuerimpuls an einen Unterbrecher 13 und dieser Unterbrecher erlaubt, in geschlossenem Zustand, den Durchfluss eines Stromes durch den Gleichrichter 14. Die Vorsehung des Gleichrichters 14 erlaubt es an seinen Ausgang 15, einen Gleichstrom zu liefern, in einer Größenordnung von 0 bis 2000 A Gleichstrom.

Somit erlaubt es die Einrichtung eine hohe Spannung zu liefern, dank der Vorsehung der Vorrichtungen 9, 10 und 12, die geeignete elektrische Merkmale aufweisen sowie einen Wechselstrom oder einen Gleichstrom mit veränderbarer Phase und Amplitude, um somit ein ordnungsgemäßes Arbeiten der Vorrichtung 'Energy Meter' 16 zu ermöglichen, Vorrichtung, die an Bord der elektrisch angetriebenen Lokomotive angeordnet ist.

Die gesamthaft mit 4 gekennzeichnete Einrichtung ist in einem Gehäuse 1 untergebracht, wie in den Figuren 1 und 2 dargestellt; über schematisch dargestellte Hubvorrichtungen gemäß Doppelpfeil 17 in Figur 3 kann die Einrichtung unter Zuhilfenahme einer Hubvorrichtung angehoben werden.

Eine entfernt angeordnete Kontrollvorrichtung 27 steht über ein Kabel 18, bestehend aus optischen Fasern mit dem Generator 5 in Wirkverbindung und somit wird es ermöglicht, einen Eingriff zur Einstellung der Signale, die vom Generator 5 erzeugt werden, durchzuführen.

Die somit erhaltenen Werte können mit den Messwerten, die von der Einrichtung 'Energy Meter' 9 kommen, verglichen werden, wobei zu berücksichtigen ist, dass diese Messungen auch auf automatiche Weise durchführbar ist.

Erfindungsgemäß ist ferner ein Übertragungskanal 19 vorgesehen, der in geeigneter Weise isoliert ist und es ermöglicht, die gemessenen Daten gemäß der Einrichtung 20 der Kontrolleinrichtung 27 zuzuleiten.

Die erhaltenen Messwerte können auch in automatischer Weise verglichen werden mit den Messdaten, die durch die Messungen mittels der Vorrichtung 'Energy Meter' zur Verfügung stehen.

Der Vergleich zwischen den Messwerten der Vorrichtung 20 mit den Messwerten der Einrichtung 'Energy Meter' 16 erlauben ein Überprüfen der Übereinstimmung gegenüber den vorgeschriebenen Werten aufgrund der Norm EN 50643.

## Patentansprüche

1. Einrichtung zum Überprüfen einer Vorrichtung des Typs 'Energy Meter', die an Bord eines elektrisch angetriebenen Zuges eingebaut ist, wobei ein Wagen mit Rädern zum Verschieben eines Generators (5) zur Erzeugung von Signalen vorgesehen ist und der Generator Verbindungen (6), Verstärker (7 und 8) überwacht, die ihrerseits mit Transformatoren (9 und 10) verbunden sind und deren Hochspannungs-Sekundärwicklung die Spannung und den Strom für die Überprüfung der Vorrichtung 'Energy Meter' (16) liefert und der Generator (5) weitere zwei Ausgänge aufweist, von denen der erste mit einem Gleichstrom-Generator (12) und der zweite Ausgang, unter Zwischenschaltung eines Unterbrechers (13), der den Transformator (9) mit einem Gleichrichter (14) verbindet, dessen Ausgänge (15) mit einer Vorrichtung des Typs 'Energy Meter' (16) wirkverbunden sind und ferner vorgesehen ist, dass die Ausgänge des Gleichrichters (14) der Transformatoren (9 und 10) sowie des Generators (12) neben einer Verbindung mit der Vorrichtung 'Energy Meter' (16) auch mit einer Prüfvorrichtung (20) verbunden sind und ferner vorgesehen ist, dass der Generator (5) über eine entfernt angeordnete Kontrolleinrichtung (27) gesteuert wird und diese Kontrolleinrichtung elektrisch isoliert von der Überwachungseinrichtung angeordnet ist.

2. Einrichtung, nach Patentanspruch 1, **dadurch gekennzeichnet, dass** ein entfernt vorgesehenes Terminal Einsatz findet, das mit dem Rest der Einrichtung über eine wireless-Verbindung oder über ein Kabel bestehend aus optischen Fasern verbunden ist.

3. Einrichtung, nach Patentanspruch 1, **dadurch gekennzeichnet, dass** ein Generator Einsatz findet, der in ihrer Form veränderbare Testwellen verwendet und mit dem entfernt angeodneten Terminal in Verbindung steht, um Testvorgänge durchzuführen, die unterschiedlich sind von den standardisierten Testvorgängen.

4. Einrichtung, nach Patentanspruch 1, **dadurch gekennzeichnet, dass** Radioverstärker Verwendung finden, um den Transformatoren die notwendige Energie zu liefern.

5. Einrichtung, nach Patentanspruch 1, **dadurch gekennzeichnet, dass** die gesamte Vorrichtung bis auf die Höhe des Zugdaches anhebbar ist.

6. Einrichtung, nach Patentanspruch 1, **dadurch gekennzeichnet, dass** in einer einzigen Vorrichtung sowohl der Generator als auch die Bezugseinrichtungen untergebracht sind.

7. Einrichtung, nach Patentanspruch 1, **dadurch gekennzeichnet, dass** in einer einzigen Vorrichtung der Generator für Spannung und Gleichstrom als auch der Generator für Spannung und Wechselstrom mit änderbarer Frequenz untergebracht sind.
